# EUROPÄISCHE PATENTSCHRIFT

(11) **EP 1 026 789 B1**
(45) Veröffentlichungstag und Bekanntmachung des Hinweises auf die Patenterteilung: **15.09.2004**
(21) Anmeldenummer: 00110759.8
(22) Anmeldetag: 09.07.1997
(51) Int. Cl.: H01R 13/639, G01R 31/04

(54) **Vorrichtung zum Prüfen eines mit Kabeln versehenen Steckers**
Device for checking a plug-type connector provided with cables
Dispositif d'essai pour un connecteur à fiche pourvu de câbles

(30) Priorität: 26.07.1996 DE 29612973 U
(43) Veröffentlichungstag der Anmeldung: 09.08.2000
(62) Teilanmeldung aus: 97111576.1
(73) Patentinhaber: TSK Prüfsysteme GmbH, 32457 Porta Westfalica (DE)
(72) Erfinder: Mohme, Heinrich, 33602 Vlotho (DE); Günther, Wolfgang, 31707 Heessen (DE); Benedix, Lutz, 31693 Hespe (DE)
(74) Vertreter: Dantz, Jan Henning

(56) Entgegenhaltungen:
- EP-A- 0 692 718
- GB-A- 2 200 503

## Beschreibung

Die vorliegende Erfindung betrifft eine Vorrichtung zum Prüfen eines mit Kabeln versehenen Steckers gemäß dem Oberbegriff des Anspruches 1.

Eine derartige Vorrichtung ist aus dem deutschen Gebrauchsmuster G 92 10 417 bekannt.

Die darin gezeigte und beschriebene Vorrichtung hat sich prinzipiell bewährt.

Allerdings ist die Funktionsfähigkeit dann etwas eingeschränkt, wenn mehrere Vorrichtungen auf einer Arbeitsplatte vorgesehen sind.

In diesem Fall ist üblicherweise nur eine zentrale Entriegelung aller Vorrichtungen möglich, es sei denn, jede einzelne Vorrichtung ist mit einem zusätzlichen Steuerorgan ausgestattet, das eine separate Entriegelung jeder einzelnen Vorrichtung ermöglicht.

Naturgemäß ist dies mit einem erheblichen baulichen Aufwand verbunden, der die Herstellungskosten jeder Vorrichtung ungünstig beeinflußt.

Der vorliegenden Erfindung liegt daher die Aufgabe zugrunde, eine Vorrichtung der gattungsgemäßen Art so zu gestalten, daß mit konstruktiv einfachen Mitteln die Funktionsfähigkeit dadurch verbessert wird, daß jede einzelne Vorrichtung von einer Vielzahl in einem Arbeitsbereich angeordneten und zentral betätigbaren Vorrichtungen entriegelbar ist.

Diese Aufgabe wird durch eine Vorrichtung gelöst, die die Merkmale des Anspruches 1 aufweist.

Durch diese konstruktiven Ausgestaltung der Vorrichtung besteht nun die Möglichkeit, ohne steuerungstechnischen Aufwand eine separate Entriegelung jeder Vorrichtung, die rein mechanisch erfolgt, vorzunehmen.

Dabei können beispielsweise zwei Vorrichtungen zum Verriegeln vorgesehen sein, von denen jeweils eine in den sich gegenüberliegenden Seitenbereichen einer Steckeraufnahme angeordnet sind.

Desweiteren zeichnet sich die neue Vorrichtung besonders dadurch aus, daß sie sehr kompakt gehalten werden kann, d. h., die Grundrißabmaße konstruktionsbedingt gering gehalten werden können, so daß diese Vorrichtung prädestiniert ist, dort eingesetzt zu werden, wo geringe Platzverhältnisse vorherrschen.

Die Arretiereinrichtung kann sowohl fest als auch lösbar mit dem Aufnahmeteil verbunden sein. Letzteres ist beispielsweise aus der DE 42 04 283 bekannt.

Vorteilhafte Ausgestaltungen der Erfindung sind in den Unteransprüchen gekennzeichnet.

Ein Ausführungsbeispiel der Erfindung wird nachfolgend anhand der beigefügten Zeichnung beschrieben.

Die einzige Figur zeigt ein Ausführungsbeispiel der Vorrichtung in einer geschnittenen Seitenansicht.

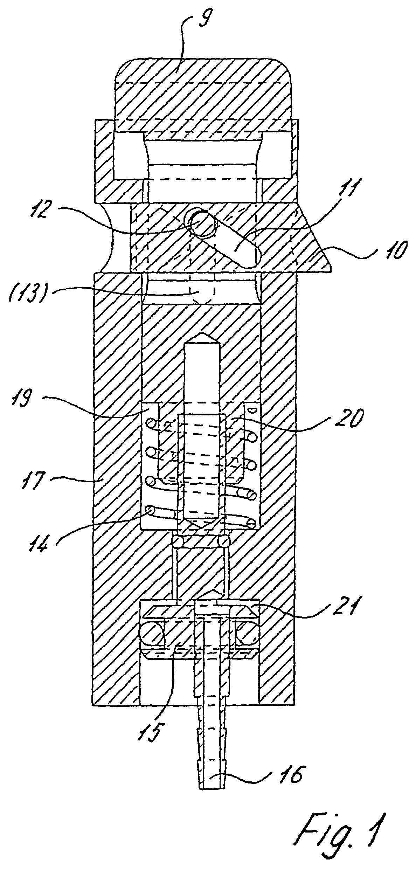

Die in der Figur 1 dargestellte Ausführungsvariante der Erfindung zeigt eine Arretiervorrichtung mit einem Gehäuse 17, das eine Kammer 19 aufweist, in der ein Taster 9 hin und her verschiebbar gelagert ist. Dabei ist auf einem Ansatz 20 des Tasters 9 eine Druckfeder geführt, die sich einerseits am Grund der Kammer 19 und andererseits an dem Taster selbst abstützt.

In dem Gehäuse 17, quer zu dessen und zur Längsachse des Tasters 9 ist ein Arretierungsstift hin und her bewegbar angeordnet, mit dem ein nicht dargestellter Stecker in einer Aufnahme arretierbar ist.

Dieser Arretierstift 10 weist ein Langloch 11 auf, das unter einem Winkel von vorzugsweise 45° schräg verläuft.

In diesem Langloch 11 ist ein fest mit dem Taster 9 verbundener Zapfen 12 geführt, so daß bei einem Eindrücken des Tasters 9 der Arretierungsstift 10 in Richtung des Gehäuses 17 zurückgezogen wird.

Das Gehäuse 17 weist ebenfalls ein Langloch 13 auf, das sich in Längsachsrichtung des Gehäuses 17 erstreckt und in das der Zapfen 12 hineinragt.

Dabei liegt der Zapfen 12 in Arretierstellung des Arretierungsstiftes 10, wie in der Figur 5 gezeigt, an der oberen Begrenzung des Langloches 13 an und bildet so einen oberen Anschlag für den Taster 9.

Beim Betätigen des Tasters 9, also beim Eindrücken, wird gleichzeitig die Druckfeder 14 zusammengedrückt, so daß nach einem Loslassen des Tasters 9 dieser in seine obere Endstellung zurückverfährt, bei gleichzeitigem Ausfahren des Arretierungsstiftes 10.

Zum Entriegeln des Arretierungsstiftes 10, vor allem wenn mehrere Arretiereinrichtungen gleichzeitig im Sinne eines Entriegelns betätigt werden sollen, ist in einem Zylinderraum 21 des Gehäuses 17 ein Kolben 15 angeordnet, der fest mit dem Taster 9 verbunden ist und der überdies einen Luftanschluß 16 aufweist, durch den Druckluft in den Zylinderraum 21 führbar ist.

Bei Beaufschlagung des Kolbens 15 mit Druckluft verschiebt sich der Kolben 15 nach unten und zieht dabei gegen die Wirkung der Druckfeder 14 den Taster 9 gleichfalls in eine untere Stellung, wobei, wie beschrieben, gleichzeitig der Arretierungsstift 10 aus seiner Arretierposition herausgezogen wird.

Auf seiner Eingriffsseite ist der Arretierungsstift 10 geschrägt, so daß ein leichtes Einführen eines Steckers möglich ist, wobei dann der Arretierungsstift 10 zurückgedrückt wird bei gleichzeitigem Verschieben des Tasters 9 gegen den Druck der Druckfeder 14.

## Patentansprüche

1. Vorrichtung zum Prüfen eines mit Kabeln versehenen Steckers auf Verrastungsund/oder Kontaktierungsfehler mit einem Aufnahmeteil, das eine der Außenkontur eines bestimmten Steckers angepaßte Steckeraufnahme aufweist, in deren mindestens einem Seitenbereich eine Arretiereinrichtung vorgesehen ist, die einen durch Druck in Arretierstellung bringbaren Arretierungsstift (10) aufweist, **dadurch gekennzeichnet, daß** die Arretiereinrichtung ein Gehäuse (17) aufweist, in dem ein federbelasteter Taster längsverschiebbar geführt ist, daß quer dazu der Arretierungsstift (10) angeordnet ist, der ein winklig, vorzugsweise unter 45° verlaufendes Langloch (11) aufweist, in dem ein fest mit dem Taster (9) verbundener Zapfen (12) geführt ist, und daß eine Druckfeder (14) vorgesehen ist, die sich einerseits an einem Gehäuseteil und andererseits am Taster (9) abstützt.

2. Vorrichtung nach Anspruch 1, **dadurch gekennzeichnet, daß** der Taster (9) einen Ansatz (20) aufweist, auf dem die Druckfeder (14) geführt ist.

3. Vorrichtung nach Anspruch 1, **dadurch gekennzeichnet, daß** das Gehäuse (17) eine Kammer (19) aufweist, in der der Taster (9) einliegt.

4. Vorrichtung nach Anspruch 1, **dadurch gekennzeichnet, daß** mit dem Taster (9) ein Kolben (15) verbunden ist, der mittels eines zuführbaren Mediums in einem Zylinderraum (21) hin und her bewegbar ist.

5. Vorrichtung nach Anspruch 1, **dadurch gekennzeichnet, daß** in dem Gehäuse (17) ein sich in Längsachsrichtung erstreckendes Langloch (13) vorgesehen ist, in dem der Zapfen (12) gelagert ist.

6. Vorrichtung nach Anspruch 1, **dadurch gekennzeichnet, daß** der Arretierungsstift (10) auf seiner der Steckeraufnahme zugewandten Seite eine Abschrägung aufweist.

7. Vorrichtung nach Anspruch 1, **dadurch gekennzeichnet, daß** der Arretierungsstift (10) in Querbohrungen verschiebbar gelagert ist.

## Claims

1. An apparatus by means of which a plug provided with cables is tested for latching and/or contact-connection faults, having an accommodating part which has a plug mount which is adapted to the outer contour of a certain plug and in at least one side region of which is provided an arresting device, which has an arresting pin (10) which can be moved into the arresting position under the action of pressure, **characterized in that** the arresting device has a housing (17) in which a spring-loaded pushbutton is guided in a longitudinally displaceable manner, **in that** the arresting pin (10) is arranged transversely thereto, and has a slot (11) which runs at an angle, preferably at 45°, and in which is guided a stub (12) which is fixed to the pushbutton (9), and **in that** a compression spring (14) is provided, this spring being supported on a housing part, on the one hand, and on the pushbutton (9), on the other hand.

2. Apparatus according to Claim 1, **characterized in that** the pushbutton (9) has an extension (20) on which the compression spring (14) is guided.

3. Apparatus according to Claim 1, **characterized in that** the housing (17) has a chamber (19) in which the pushbutton (9) is positioned.

4. Apparatus according to Claim 1, **characterized in that** a piston (15) is connected to the pushbutton (9), it being possible for this piston to be moved back and forth in a cylinder space (21) by means of a suppliable medium.

5. Apparatus according to Claim 1, **characterized in that** the housing (17) contains a slot (13) which extends in the direction of the longitudinal axis and in which the stub (12) is mounted.

6. Apparatus according to Claim 1, **characterized in that** the arresting pin (10) has a bevel on its side which is directed towards the plug mount.

7. Apparatus according to Claim 1, **characterized in that** the arresting pin (10) is mounted in a displaceable manner in transverse bores.

## Revendications

1. Dispositif pour contrôler des défauts d'accrochage et/ou de mise en contact d'un connecteur à fiche pourvu de câbles, comportant une partie de réception qui comprend un logement de connecteur adapté au contour extérieur d'un connecteur déterminé, dans au moins une zone latérale duquel est prévu un dispositif d'arrêt qui comporte un doigt d'arrêt (10) pouvant être amené par pression en position d'arrêt, **caractérisé en ce que** le dispositif d'arrêt comporte un bottier (17) dans lequel est guidé, de manière à coulisser longitudinalement, un palpeur soumis à l'action d'un ressort, **en ce que** transversalement à ceci est disposé le doigt d'arrêt (10) qui présente un trou oblong (11) s'étendant suivant un angle, de préférence de 45°, dans lequel est guidée une tige (12) solidaire du palpeur (9), et **en ce qu'**il est prévu un ressort de compression (14) qui prend appui d'une part contre une partie du boîtier et d'autre part contre le palpeur (9).

2. Dispositif selon la revendication 1, **caractérisé en ce que** le palpeur (9) présente un appendice (20) sur lequel est guidé le ressort de compression (14).

3. Dispositif selon la revendication 1, **caractérisé en ce que** le boîtier (17) comporte une chambre (19) dans laquelle se trouve le palpeur (9).

4. Dispositif selon la revendication 1, **caractérisé en ce qu'**au palpeur (9) est relié un piston (15) qui est déplaçable en sens alternés dans une chambre de cylindre (21), au moyen d'un fluide pouvant être amené.

5. Dispositif selon la revendication 1, **caractérisé en ce que** dans le boîtier (17) est prévu un trou oblong (13) s'étendant dans la direction de l'axe longitudinal; dans lequel est montée la tige (12).

6. Dispositif selon la revendication 1, **caractérisé en ce que** le doigt d'arrêt (10) présente un chanfrein sur son côté tourné vers le logement de connecteur.

7. Dispositif selon le revendication 1, **caractérisé en ce que** le doigt d'arrêt (10) est monté de manière à pouvoir coulisser dans des perçages transversaux,
